# NEUE EUROPÄISCHE PATENTSCHRIFT

(11) **EP 0 756 742 B2**
(45) Veröffentlichungstag und Bekanntmachung des Hinweises auf die Entscheidung über den Einspruch: **30.10.2002**
(45) Hinweis auf die Patenterteilung: 16.06.1999
(21) Anmeldenummer: 95909610.8
(22) Anmeldetag: 02.03.1995
(51) Int. Cl.: G10L 15/26

(54) **VERFAHREN UND VORRICHTUNG ZUR SPRACHGESTEUERTEN FERNBEDIENUNG ELEKTRISCHER VERBRAUCHER**
SPEECH-CONTROLLED REMOTE CONTROL PROCESS AND DEVICE FOR ELECTRICAL CONSUMERS
PROCEDE ET DISPOSITIF DE TELECOMMANDE VOCALE DE CONSOMMATEURS ELECTRIQUES

(30) Priorität: 21.04.1994 CH 124094
(43) Veröffentlichungstag der Anmeldung: 05.02.1997
(73) Patentinhaber: INFO BYTE AG, 5704 Egliswil (CH)
(72) Erfinder: MÜHLING, Frank, CH-5103 Wildegg (CH)
(74) Vertreter: Schwabe, Hans-Georg, Dipl.-Ing.
(86) Internationale Anmeldenummer: CH9500047
(87) Internationale Veröffentlichungsnummer: WO95029481

(56) Entgegenhaltungen:
- AT-A- 376 538
- DE-A- 4 219 106
- DATABASE WPIL, Nr. 92-055 708, DERWENT DATABASE WPIL, Nr. 92-055 708, DERWENT PUBLICATIONS LTD., London; & International PUBLICATIONS LTD., London; & International Technical Disclosure no. 01, 25-01-1992 Technical Disclosure no. 01, 25-01-1992
- DATABASE WPIL, Nr. 94-306 979, DERWENT DATABASE WPIL, Nr. 94-306 979, DERWENT PUBLICATIONS LTD., London; & JP-A-06 233 PUBLICATIONS LTD., London; & JP-A-06 233 359 (SONY CORP.), 359 (SONY CORP.),

## Beschreibung

Die vorliegende Erfindung betrifft ein Verfahren und eine Vorrichtung zur Fernbedienung elektrischer Verbraucherdurch Sprachbefehle, wobei ein handelsüblicher Personalcomputer (PC) als Zentraleinheit, die die Sprachbefehle empfängt, erkennt und in entsprechende Steuerbefehle zur Steuerung der Verbraucher umsetzt, mindestens ein Sprachkanal mit einem elektroakustischen Wandler, der an den PC über eine Sprachkanalschnittstelle angeschlossen ist, und ein mit der Zentraleinheit und den Verbrauchern verbundenes Fernsteuerungsnetzwerk vorgesehen sind und ein handelsübliches Spracherkennungsprogramm in dem PC implementiert ist.

Ein solches Verfahren und eine solche Vorrichtung sind durch die DE 4 214 668 A1 bekannt geworden.

Für handelsübliche Personalcomputer werden in der letzten Zeit preiswerte Sprachkommunikationssysteme zur Kommunikation mit dem Computer angeboten. Das in der oben genannten DE 4 214 668 A1 beschriebene Fernbedienungssystem hat sich dies zunutze gemacht, um mit Hilfe des im Computer implementierten Spracherkennungssystems die zur Fernsteuerung angeschlossener elektrischer Verbraucher benötigten Steuersignale zu erzeugen. Dieses bekannte Verfahren benutzt auch eine auf einem Monitor des PCs dargestellte grafische Benutzeroberfläche zur Darstellung eines Codeworts zum Abruf abgespeicherter individueller Einstellungen für den jeweiligen elektrischen Verbraucher.

Die Entgegenhaltung (DE-A-4 219 106 DEUTSCHE AEROSPACE AG, 16. Dezember 1993, zusammenfassung) betrifft ein sprachgesteuertes Auskunftsund/oder Bestellsystem mit einem Zentralrechner, welcher mit einem Spracherkenner und einem Zentral-Datenspeicher ausgerüstet ist, sowie mit mindestens einem Spracheingabe/Sprachausgabegerät, welches über ein Telefonnetz mit dem Zentralrechner verbunden ist. Zur Verbesserung der Flexibilität und der Effizienz eines solchen Systems bei der Abwicklung des Dialogs des Anrufers mit dem Zentralrechner schlägt diese Druckschrift vor, dem Spracheingabe/Sprachausgabegerät ein mit dem Zentralrechner verbundenes Anzeigegerät zur visuellen Anzeige von vom zentralrechner übermittelten Informationen räumlich zuzuordnen. Bei diesem sprachgesteuerten Auskunfts- und/ oder Bestellsystem handelt es sich nicht um eine Fernbedienung oder Femsteuerung. Eine Übertragung von Infrarotsignalen wird lediglich für die Kommunikation zwischen dem Spracheingabe/ Sprachausgabegerät, z.B. einem modifizierten Telefonendgerät und dem Anzeigegerät vorgeschlagen.

Viele auf dem Markt befindliche elektrische Haushaltsgeräte, insbesondere solche der Unterhaltungselektronik, können heutzutage mit Hilfe einer kleinen, handlichen Fernbedienungseinheit durch die Übertragung von Infrarotsignalen zum elektrischen Gerät ferngesteuert werden. Eine solche Fernsteuerung schliesst z.B. bei HIFI-Geräten mannigfaltige Funktionen ein, wie eine Umschaltung vom Stand-by-Betrieb zum Dauerbetrieb, eine Kanalwahl, eine Lautstärkeregelung etc. Die Infrarotfernbedienung hat sich in dieser Art als besonders zuverlässig und störsicher herausgestellt. Allerdings sind solche Infrarotfernbedienungen immer nur auf ein einzelnes Gerät oder eine funktionell zusammengehörige Gerätegruppe ausgelegt, und es besteht auch keine Möglichkeit der Fernbedienung über mehrere Räume hinweg.

Die Entgegenhaltung (DATABASE WPIL Nr. 92-055 708, DERWENT PUBLICATIONS LTD., London; & TP-A-19 201 (ANONYMOUS)) schlägt für eine auf Infrarotsignalübertragung beruhende Fernbedienung oder Fernsteuerung zwei unterschiedliche Systeme vor:
a) Ein tragbares, tastenloses Fernbediengerät sendet Infrarotoder Funk-Fernbediensignale an elektronische Einrichtungen, wobei die Fernbedienbefehle statt durch Tasten durch eine Spracheingabe an dem Fembediengerät eingegeben werden.
b) Das zweite System schlägt eine stationäre Grundeinheit vor, deren Funktionen dieselben sind wie die des oben erwähnten Fernbediengeräts. Die stationäre Grundeinheit ist an einem Ort plaziert, von dem aus das fernzubedienende Gerät sichtbar ist. Anders als bei der tragbaren Version a) kann die stationäre Einheit aus der Ferne eingegebene Sprachbefehle, z.B. durch das Telefonnetz, empfangen.

Aus der AT-A-376 538 ist eine Fernsteuerung für nachrichtentechnische Geräte bekannt, wobei ein Fernbedienungsgeber mit einem Mikrophon verbunden ist, das an einen Sprachanalysator angeschlossen ist und Wortbefehle in elektrische Signale umsetzt und analysiert. Ein dem Wortbefehl entsprechender Steuerbefehl steuert eine Sendestufe an, welche z.B. ein Infrarot-Signal zu einem zugeordneten Empfänger überträgt.

Die Aufgabe der vorliegenden Erfindung besteht somit darin, ein gattungsgemässes Verfahren und ein gattungsgemässes System zur sprachgesteuerten Fernbedienung elektrischer Verbraucher so zu ermöglichen, dass der als Zentraleinheit dienende PC die Fernbedienungssteuersignale störsicher, kostengünstig und zuverlässig an unterschiedlichste Gerätetypen, die auch in verschiedenen Räumen stehen können, übertragen kann.

Diese Aufgabe wird erfindungsgemäss durch die in den unabhängigen Ansprüchen 1 und 4 gekennzeichneten Merkmale gelöst.

Vorteilhafte Ausführungsarten dieses Verfahrens und Systems sind in den davon abhängigen Ansprüchen gekennzeichnet.

Besonders vorteilhaft ist, dass der standardisierte Infrarotcodesatz am PC eingebbar, änderbar und einem jeweiligen Verbraucher zuordenbar ist. Dabei kann vorteilhafterweise, jedem beliebigen Verbraucher ein jeweiliger Codesatz zugeordnet werden, wobei sich die Codesätze untereinander unterscheiden können. Wenn, wie bevorzugt, an einem Monitor des PCs eine Bildanzeige in Form einer grafischen Benutzeroberfläche erzeugt wird, so lässt sich diese jedem fernzubedienenden Verbraucher leicht zuordnen. Diese Zuordnung kann durchaus durch die jeweilige grafische Ausgestaltung dieser Benutzeroberfläche geschehen. Die jeweils eingegebenen Sprachbefehle können nach ihrer Erkennung in einen Infrarotcodesatz umgewandelt und dann auf dem Monitor grafisch dem zu steuernden Gerät zugeordnet werden. Heute handelsübliche, grafische Benutzeroberflächen erlauben es selbstverständlich, dass Änderungen sowohl des Codesatzes als auch Änderungen der Form der grafischen Benutzeroberfläche selbst durch Befehle, z.B. über die Tastatur oder eine Maus eingegeben werden können. Dabei können getätigte Eingaben als Protokoll gespeichert werden. Ferner kann mit Hilfe heutiger Sprachausgabemodule der PC auch eine akustische Rückmeldung an den Benutzer erzeugen.

Bevorzugt bearbeitet der PC auch komplexe eingebbare, speicherbare und anzeigbare Bedienungsabläufe, welche auf eine entsprechende Eingabe hin zu einem beliebigen späteren Zeitpunkt ausgeführt werden können.

Ein gattungsgemässes System zur sprachgesteuerten Fernbedienung elektrischer Verbraucher ist gemäss Anspruch 4 dadurch gekennzeichnet, dass das Fernsteuerungsnetzwerk eine Glasfaserleitung zum Übertragen von IR-Steuercodes und eine Infrarotübertragungsstrecke aufweist,
dass der PC Speichermittel zum Speichern eines IR-Codesatzes und Codiermittel zum Codieren jedes vom implementierten Spracherkennungsprogramm entsprechend dem empfangenen Sprachbefehl erzeugten Steuerbefehls in Form von IR-codierten Signalen sowie Mittel zum Übertragen der IR-codierten Signale über das Fernsteuerungsnetzwerk zu dem jeweils angesprochenen elektrischen Verbraucher aufweist, und
dass den Verbrauchern ein Infrarotempfänger zugeordnet ist, der das jeweilige über das Fernsteuerungsnetz und die IR-Übertragungsstrecke übertragenes IR-Signal empfängt.

Am PC kann eine übliche Eingabevorrichtung, wie zum Beispiel eine Tastatur dazu dienen, einen IR-Codesatz einzugeben, zu ändern und diesen einem jeweiligen Verbraucher zuzuordnen. An der Sprachkanalschnittstelle des PC können ein oder mehrere elektroakustische Wandler angeschlossen werden, wobei mehrere Sprachkanäle auch auf mehrere Räume verteilt sein können.

Je nach Einsatzzweck des erfindungsgemässen Systems zur sprachgesteuerten Fernbedienung kann das Fernsteuerungsnetzwerk entweder sternförmig zu den einzelnen Verbrauchern geführt sein oder auch eine Busstruktur haben.

Vorschlagsgemäss wird zur Spracherkennung ein handelsübliches, in einem handelsüblichen PC implementiertes Spracherkennungssystem verwendet. Dieses Spracherkennungssystem kann die durch die Spracherkennung aufgrund der eingegebenen Sprachbefehle gewonnene Information an andere Programme weitergegeben. Diese Information wird aufgenommen und mit den möglichen Fernbedienungsbefehlen zur Steuerung der elektrischen Verbraucher verglichen. Sobald ein Befehl erkannt ist, wird im Speicher nach diesem Befehl gesucht, und es findet sich zum Beispiel die Information, dass der Rundfunkempfänger umgeschaltet werden soll, und gegebenenfalls zusätzlich die Information, in welchem Raum sich der Rundfunkempfänger befindet. Dann wird das dazugehörige infrarotcodierte Signal zum entsprechenden Raum übertragen und dort ausgestrahlt, was zum Umschalten des Rundfunkgerätes führt.

Durch das erfindungsgemässe Verfahren und das erfindungsgemässe System ist es möglich, eine Kombination einer Spracheingabeeinheit mit einer Ablaufsteuerung in einfachster Weise durchzuführen. Zusätzlich ermöglichen das Verfahren und das System auch einen zeitverschobenen Ablauf einer Steuersequenz. Zum Beispiel kann der Benutzer vor Antritt eines Urlaubs eine Zeitprogrammierung vornehmen und eine beliebige Ablaufsteuerung unter Zugrundelegung der programmierten Zeit für die Dauer seiner Abwesenheit programmieren.

Ein zusätzlicher Vorteil des erfindungsgemässen Systems ist es, dass der Benutzer auf dem PC-Monitor jederzeit kontrollieren kann, welche Eingabe er wann getätigt hat.

Nachfolgend wird die Erfindung anhand der beiliegenden Zeichnungsfiguren näher beschrieben.

Die Zeichnungsfiguren zeigen jeweils:
Figur 1 ein Blockdiagramm eines Systems zur sprachgesteurten Fernbedienung mehrerer Verbraucher mit einem sternförmigen Fernsteuerungsnetz;
Figur 2 ein System zur sprachgesteuerten Fernbedienung mehrerer elektrischer Verbraucher, bei dem das Femsteuerungsnetzwerk BuSstruktur hat;
Figur 3 eine erste Ausführungsart des erfindungsgemässen Systems zur sprachgesteuerten Fembedienung, bei dem das Fernsteuerungsnetzwerk eine Übertragung von Infrarotsignalen über eine Glasfaserleitung vorsieht; und
Figur 4 schliesslich eine vereinfachte Ausführungsart ein Systems zur sprachgesteuerten Fernbedienung mehrerer Verbraucher, bei dem die Verbraucher lediglich einund ausgeschaltet werden.

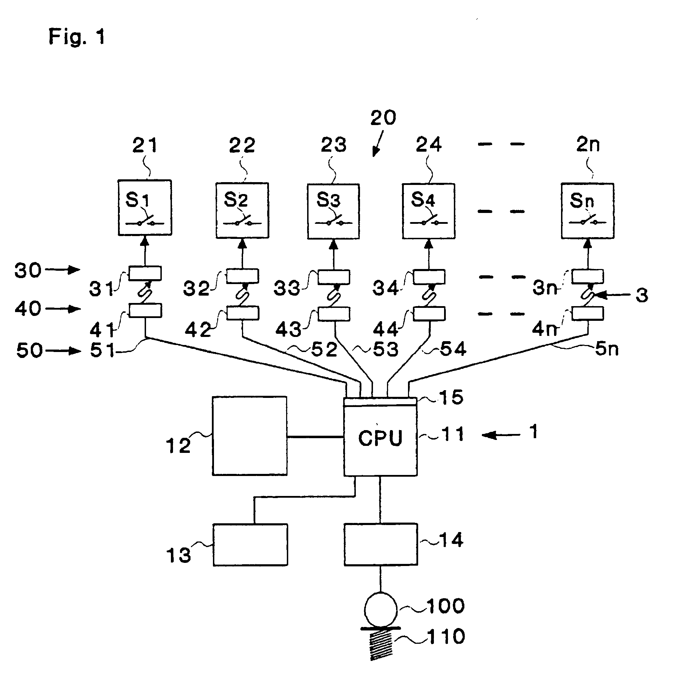

Bei der in der Figur 1 dargestellten Ausführungsart sind mit einem Standard-PC 1, welcher in üblicher Weise eine CPU 11, einen Monitor 12 und eine Tastatur 13 aufeist, über eine Sprachkanalschnittstelle 14 ein elektroakustischer Wandler 100 und über eine Femsteuerungsschnittstelle 15 ein Fernsteuerungsnetzwerk 50 verbunden. Der elektroakustische Wandler 100 definiert einen Sprachkanal 110. Im PC 1 ist ein Spracherkennungssystem implementiert, das die Fernbedienungs-Sprachbefehle, die über den Sprachkanal 110 zum elektroakustischen Wandler 100 und von dort über die Sprachkanalschnittstelle 14 zur CPU gelangen, erkennt und die durch die Spracherkennung gewonnene Information an andere Programme weitergeben kann. Bevorzugt ist für die Spracherkennung ein handelsübliches Softwarepaket implementiert. An der Fernsteuerungsschnittstelle 15 des PC 1 ist das Femsteuerungsnetzwerk 50 sternförmig angeschlossen. Das heisst, dass sternförmig einzelne, getrennte Leitungssysteme 51, 52, 53, 54, ..., 5n zu elektrooptischen Wandlern 41, 42, 43, 44, ..., 4n geführt sind, die die über die Leitungssysteme 51-5n zugeführten elektrischen infrarotcodierten Signale in optische Infrarotsignale umsetzen. Diese Infrarot signale gelangen über eine Infrarotübertragungsstrecke 3 zu Infrarotempfängern 30, die jeweils den Verbrauchern 21, 22, 23, 24, ..., 2n zugeordnet sind. Als zu steuerndes Glied ist in jedem Verbraucher ein Schalter S1, S2, S3, S4 ..., Sn dargestellt. Selbstverständlich dienen die als zu steuernden Elemente dargestellten Schalter nur als Beispiel, und es können die verschiedensten Funktionen der jeweiligen Geräte durch das sprachgesteuerte Fernbedienungssystem gesteuert werden.

Die in Figur 1 dargestellte Ausführungs ein sprachgesteuerten Fernbedienungssystems eignet sich insbesondere, wenn eine geringere Anzahl von Verbrauchern, die sich in wenigen getrennten Räumen befinden, fernbedient werden soll. Wird nämlich die Anzahl der Verbraucher grösser und sind die Verbraucher über eine grössere Entfernung, das heisst beispielsweise über mehrere Zimmer eines Gebäudes verteilt, wird der Aufwand für die Verkabelung des Fernsteuerungsnetzwerkes gross. Ferner kann dann das Fernsteuerungsnetzwerk störanfällig werden.

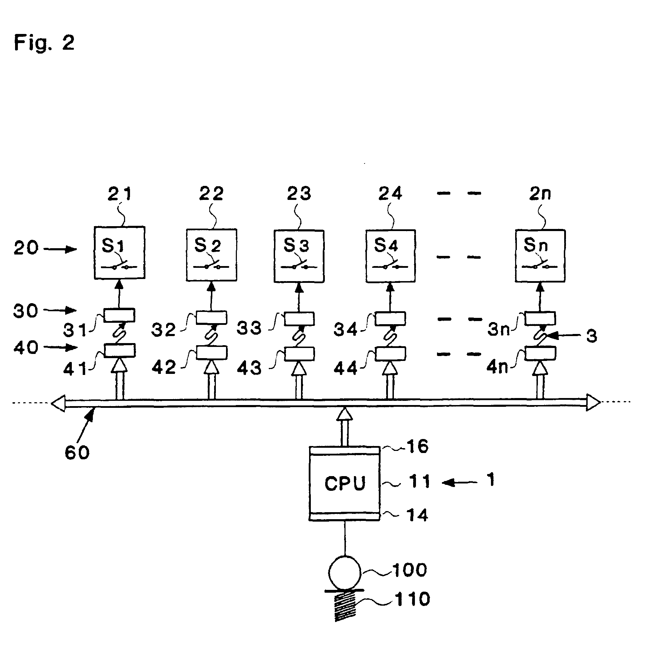

Figur 2 zeigt ein Fernbedienungssystem, bei dem das Fernsteuerungsnetzwerk Busstruktur hat. Der prinzipielle Aufbau des Standard-PCs 1 kann in Figur 2 derselbe sein, wie er in Figur 1 gezeigt ist. Die Schnittstelle 16 zum Fernsteuerungsnetzwerk ist eine Busschnittstelle. Das Leitungssystem zu den einzelnen Infrarotsendern 40 ist in Form eines Busses 60 ausgeführt. Das heisst, jeder Infrarotsender 40 muss einen Empfängerteil zum Empfang der vom PC 1 über den Bus 60 übertragenen elektrischen Signale aufweisen. Die sonstige Struktur des Fernsteuerungsnetzwerkes mit den Infrarotübertragungsstrecken 3, den Infrarotempfängern 30 und den Leitungen zu den einzelnen elektrischen Verbrauchern 20 ist identisch mit der in Figur 1 gezeigten Netzwerkstruktur. Wie dem Fachmann geläufig, hat eine Busstruktur im allgemeinen den Vorteil, dass der Verkabelungsaufwand sowie die Störanfälligkeit der übertragenen Signale bei grösseren Systemen verringert ist. Dies trifft vor allem zu bei Fernbedienungssystemen mit einer grösseren Anzahl von Verbrauchern, die über eine Anzahl von Räumen in einem Gebäude oder über mehrere Gebäude hinweg verteilt sein können.

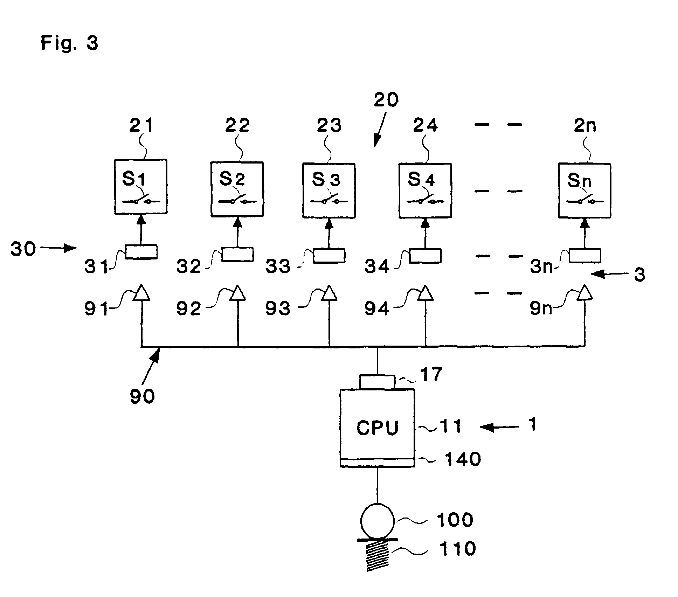

Eine Variante des erfindungsgemässen sprachgesteuerten Fernbedienungssystems ist in Figur 3 gezeigt. Die Struktur des PCs 1 ist mit der Struktur identisch, die die Figuren 1 und 2 zeigen. Die Schnittstelle 17 zum Fernsteuerungsnetzwerk beinhaltet jedoch einen Infrarotsender, so dass die zur Fernbedienung vom PC 1 ausgesendeten. IR-codierten Signale über diese Schnittstelle 17 durch ein Glasfaserleitungssystem 90 direkt über Infrarotterminals 91, 92, 93, 94, ... 9n über eine Infrarotübertragungsstrecke zu den den Verbrauchern 20 zugeordneten Infrarotempfängern 31, 32, 33, 34, ..., 3n übertragen werden können.

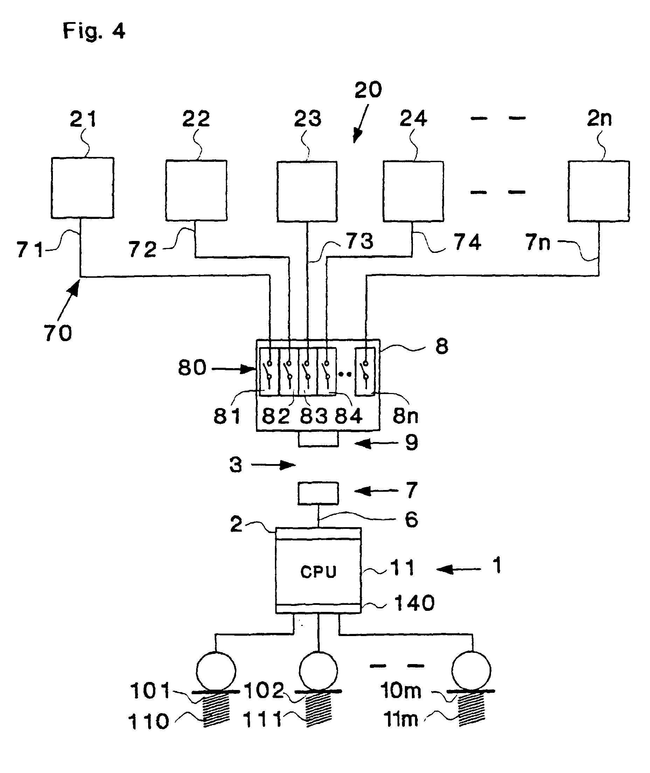

Eine vereinfachte Struktur eines sprachgesteuerten Fernbedienungssystems ist schliesslich in Figur 4 dargestellt. Die über den PC 1 eingegebenen Sprachbefehle haben hier lediglich die Funktion, einzelne Verbraucher ein- und auszuschalten. Dementsprechend sind auch das im PC implementierte Spracherkennungssystem sowie der darin gespeicherte IR-Codesatz gegenüber den zuvor beschriebenen Ausführungsarten vereinfacht. Von den Verbrauchern 20 führen jeweils Stromversorgungsleitungen 71, 72, 73, 74, ..., 7n zu Schaltkontakten 81, 82, 83, 84, ..., 8n von Schaltrelais 80, welche bevorzugt in einem zentralen Schaltkasten 8 vorgesehen sind. Zu dem zentralen Schaltkasten 8 führt vom PC 1 über eine Schnittstelle 2 ein Fernsteuerungsnetz, das hier eine einfache Punktzu-Punkt-Verbindung ermöglicht. Diese Punkt-zu-Punkt-Verbindung besteht aus einem elektrischen Leitungssystem 6, einem als IR-Sender wirkenden elektrooptischen Wandler 7, einer IR-Übertragungsstrecke 3 und einem IR-Empfänger 9. Die über dieses einfache Fernsteuerungsnetzwerk gelangenden Fernsteuerungssignale wirken auf die Schaltrelais 80 zum Einund Ausschalten der an den Schaltkontakten einzeln angeschlossenen Stromversorgungsleitungen, die zu den Verbrauchern 20 geführt sind.

In Figur 4 ist auch gezeigt, dass mehrere Sprachkanäle 110, 111, ... IIn für eine mehrkanalige Spracheingabe in den PC 1 vorgesehen sein können. Die Schnittstelle 140 muss dann natürlich dafür ausgelegt sein, dass mehrere elektroakustische Wandler 101, 102, ..., 10n anschliessbar sind. Ohne Probleme lässt sich auch eine hierarchische Ordnung oder eine Prioritätsordnung unter den einzelnen Sprachkanälen z.B. durch eine geeignete Softwaresteuerung erzielen.

Selbstverständlich können die verschiedenen Ausführungen des Fernsteuerungsnetzwerkes, wie sie in den Figuren 1 bis 4 gezeigt sind, die parallele als auch die serielle Übertragung der IR-codierten Fernsteuerungssignale vorsehen. Beispielsweise können Haupt-Schaltfunktionen einzelner Geräte auch durch separat geführte Übertragungsleitungen des Fernsteuerungsnetzwerkes übertragen werden, um die Störsicherheit der Übertragung der Fernsteuerungssignale zu erhöhen. Bei der in Figur 4 gezeigten Variante, bei der mehrere Sprachkanäle vorgesehen sind, können die einzelnen elektroakustischen Wandler in funktioneller als auch räumlicher Zuordnung zu den einzelnen Zuordnung zu den einzelnen gesteuerten elektrischen Verbrauchern stehen. Selbstverständlich lassen sich die oben beschriebenen Merkmale der einzelnen Ausführungsarten auch kombiniert in dem erfindungsgemässen sprachgesteuerten Fernbedienungssystem verwirklichen.

## Patentansprüche

1. Verfahren zur Fernbedienung elektrischer Verbraucher (20) durch Sprachbefehle, wobei ein handelsüblicher Personalcomputer (PC) (1) mit einer Sprachkanalschnittstelle (14; 140), die die Sprachbefehle erkennt und in entsprechende Steuerbefehle zur Steuerung der Verbraucher (20) umsetzt, mindestens ein Sprachkanal (110) mit einem elektroakustischen Wandler (100), der an den PC (1) über die Sprachkanalschnittstelle (14; 140) angeschlossen ist, und ein mit dem PC (1) und dem oder den Verbrauchern verbundenes Fernsteuernetzwerk mit Glasfaserleitung (90) vorgesehen sind, und im PC (1) ein handelsübliches Spracherkennungsprogramm implementiert ist, mit den Schritten:
a) Vorsehen und Speichern einer Codiereinheit im PC (1) zum Kodieren jedes vom Spracherkennungsprogramm entsprechend jedem empfangenen Sprachbefehl erzeugten Steuerbefehls in Form eines Codes, der am PC (1) eingebbar, änderbar und einem jeweiligen Verbraucher (20) zuordenbar ist und am PC (1) eine jedem der zu steuernden Verbraucher (20) entsprechende Bildanzeige in Form einer graphischen Benutzeroberfläche erzeugbar ist, der jeweils Sprachbefehle und ein Codesatz zuordenbar sind,
c) Ausgeben und Leiten der IR-Signale über das Fernsteuernetzwerk mit Glasfaserleitung (90) zu dem jeweils angesprochenen elektrischen Verbraucher (20),
b) Umsetzen des Codes in IR-Signale durch einen elektrooptischen Wandler (17)
d) wobei das jeweilige IR-Signal von einem Infrarotempfänger (30) empfangen und in elektrische Steuersignale zur Steuerung des jeweiligen elektrischen Verbrauchers (20) umgewandelt wird.

2. Fernbedienungsverfahren nach Anspruch 1, **dadurch gekennzeichnet, dass** der Code Codesätze umfasst, die jedem der Verbraucher zuordenbar sind.

3. Fernbedienungsverfahren nach Anspruch 1 oder 3, **dadurch gekennzeichnet, dass** am PC (1) komplexe Bedienungsabläufe eingebbar, speicherbar und anzeigbar sind und auf eine entsprechende Eingabe am PC (1) hin zu einem beliebigen späteren Zeitpunkt ausgeführt werden können.

4. System zur sprachgesteuerten Fernbedienung elektrischer Verbraucher, mit
- einem Personalcomputer (PC) (1) als Zentraleinheit, die eine Sprachkanalschnittstelle (14; 140) zum Empfang und zur Erkennung von Sprachbefehlen zur Umsetzung derselben in entsprechende Steuerbefehle zur Steuerung der Verbraucher (20) aufweist,
- wenigstens einem Sprachkanal (110), der über einen elektroakustischen Wandler (100) über die Sprachkanalschnittstelle (14, 140) am PC (1) angeschlossen ist, und
- einem den oder die Verbraucher (20) mit dem PC (1) verbindenden Fernsteuernetzwerk mit Glasfaserleitung (90), wobei ein handelsübliches Spracherkennungsprogramm im PC (1) implementiert ist,
wobei das Fernsteuernetzwerk eine Infrarotübertragungsstrecke (3) umfasst und der PC (1) aufweist:
- Speichermittel um Speichern eines Codes und Codiermittel zum Kodieren jedes aufgrund des von dem Spracherkennungsprogramm empfangenen Sprachbefehls erzeugten Steuerbefehls in Form von kodierten Signalen,
- eine Eingabevorrichtung (13) zum Eingeben und zum Ändern des Codes und um diesen einem jeweiligen Verbraucher (20) zuzuordnen, sowie
- einen Monitor, der am PC (1) angeschlossen ist, auf dem eine vom PC (1) jedem Verbraucher zuordenbare Bildanzeige in Form einer graphischen Benutzeroberfläche erzeugbar ist,
- eine Schnittstelle (17) zum Fernsteuernetzwerk mit einem Infrarotsender;
- Mittel zum Übertragen der IR-kodierten Signale über das Fernsteuernetzwerk mit Glasfaserleitung (90) zu dem jeweils angesprochenen elektrischen Verbraucher (20), und
wobei ein dem Verbraucher (20) zugeordneter Infrarotempfänger (30) das jeweilige über das Fernsteuernetzwerk mit Glasfaserleitung (90) und die IR-Übertragungsstrecke (3) übertragene IR-Signal empfängt.

5. Fernbedienungssystem nach Anspruch 4, **dadurch gekennzeichnet, dass** der Code Standardcodesätze jeder beliebigen Fernbedienung für alle anschliessbaren Verbrauchertypen umfasst.

6. Fernbedienungssystem nach Anspruch 4 oder 5, **dadurch gekennzeichnet, dass** am PC (1) über die Sprachkanalschnittstelle (140) mehrere getrennte elektroakustische Wandler (100, 101, 102 ...) anschliessbar sind und mehrere Sprachkanäle (110, 111, 112, ...) auf mehrere Räume verteilt sind.

7. Fernbedienungssystem nach Anspruch 4 oder 5, **dadurch gekennzeichnet, dass** das Fernsteuerungsnetzwerk (50) sternförmig zu den einzelnen Verbrauchern (20) geführt ist.

8. Fernbedienungssystem nach Anspruch 4 oder 5, **dadurch gekennzeichnet, dass** das Fernsteuerungsnetzwerk (6) Busstruktur hat.

## Claims

1. Process for the remote control of electrical consumers (20) by way of speech commands, in which a standard, commercially available personal computer (PC) (1) with a speech channel interface (14; 140) which recognizes the speech commands and transforms them into corresponding control commands for controlling the consumers (20), at least one speech channel (110) with an electro-acoustic transducer (100) which is connected to the PC (1) via the speech channel interface (14; 140), and a remote control network with fiber-optic cable (90), said network being connected to the PC (1) and the consumer(s), with a standard, commercially available speech recognition program being implemented in the PC (1), with the steps:
a) provision and storage of an encoding unit in the PC (1) for encoding, in the form of a code, every control command generated by the speech recognition program in accordance with each speech command received, said code being capable of being entered, modified and assigned to a corresponding consumer (20) via the PC (1), with an image display corresponding to each of the consumers (20) to be controlled capable of being generated on the PC (1) in the form of a graphic user interface to which the respective speech commands and a codeset can be assigned.
b) transformation of the code into infrared signals by an electro-optical transducer (17)
c) output and transmission of the infrared signals via the remote control network with fiber-optic cable (90) to the respective target electrical consumer (20),
d) the respective infrared signal being received by an infrared receiver (30) and transformed into electrical control signals for controlling the respective electrical consumer (20).

2. Remote control process according to Claim 1, **characterized by** the code comprising codesets, said codesets being capable of being assigned to each of the consumers.

3. Remote control process according to Claim 1 or 3, **characterized by** complex operator control sequences capable of being entered, stored and displayed on the PC (1) and carried out at any later time desired in accordance with an accompanying entry made via the PC (1).

4. System for the speech-controlled remote control of electrical consumers, featuring
- a personal computer (PC) (1) as the CPU, said CPU featuring a speech channel interface (14; 140) for receiving and recognizing speech commands for the transformation of same into corresponding control commands for controlling the consumers (20),
- at least one speech channel (110) which is connected to the PC (1) via an electro-acoustic transducer (100) by way of the speech channel interface (14,140), and
- a remote control network with fiber-optic cable (90) connecting the consumer(s) (20) with the PC (1), with a standard, commercially available speech recognition program being implemented in the PC (1),
said remote control network comprising an infrared transmission link (3) and the PC (1) featuring:
- a storage means for storing a code and an encoding means for encoding, in the form of encoded signals, every speech command generated on the basis of the speech command received by the speech recognition program,
- an input device (13) for inputting and modifying the code and assigning it to a corresponding consumer (20), as well as
- a monitor connected to the PC (1), on which monitor an image display capable of being assigned to any consumer can be generated by the PC (1) in the form of a graphic user interface,
- an interface (17) to the remote control network with an infrared transmitter,
- means for transmitting the encoded infrared signals via the remote control network with fiber-optic cable (90) to the respective target electric consumer (20), and
an infrared receiver (30) assigned to the consumer (20) receiving the respective infrared signal transmitted via the remote control network with fiber-optic cable (90) and the infrared transmission link (3).

5. Remote control system according to Claim 4, **characterized by** the code comprising the standard codesets of any remote control unit for all the consumer types capable of being connected.

6. Remote control system according to Claim 4 or 5, **characterized by** several separate electro-acoustic transducers (100, 101, 102, ...) being capable of being connected to the PC (1) via the speech channel interface (140) and several speech channels (110, 111, 112, ...) being distributed over several rooms.

7. Remote control system according to Claim 4 or 5, **characterized by** the remote control network (50) being connected to the individual consumers (20) in a star topology.

8. Remote control system according to Claim 4 or 5, **characterized by** the remote control network (6) featuring a bus topology.

## Revendications

1. Procédé pour la commande à distance de consommateurs électriques (20) par des ordres vocaux, prévoyant un ordinateur personnel courant sur le marché (PC) (1) muni d'une interface vocale (14 ; 140) qui identifie les ordres vocaux et les transforme en ordres pour la commande des consommateurs (20), d'au moins un canal vocal (110) avec un convertisseur électroacoustique (100), connecté au PC (1) par l'interface de canal vocal (14 ; 140) et d'un réseau de commande à distance, avec une ligne en fibres de verre (90), relié au PC (1) et au ou aux consommateurs, un programme courant d'identification vocal étant installé dans le PC (1), comportant les étapes consistant :
a) à prévoir et enregistrer au moyen du PC (1) une unité de codage pour, sous forme d'un code pouvant être saisi, modifié et attribué à un consommateur spécifique (20) depuis le PC (1), coder chaque ordre de commande généré par le programme d'identification vocale pour chaque ordre vocal reçu, et permettant, depuis le PC (1), de générer pour chaque consommateur à commander (20) un affichage optique sous forme d'un environnement graphique auquel les ordres vocaux et lots de codes peuvent être attribués,
b) à transformer le code en des signaux IR grâce à un convertisseur électro-optique (17),
c) à éditer et diriger les signaux IR par le réseau de commande à distance, muni de la ligne à fibres de verre (90), vers les différents consommateurs électriques (20) concernés,
d) le signal IR correspondant étant reçu par un récepteur infrarouge (30) et étant converti en des signaux de commande électriques destinés à la commande du consommateur électrique (20) concerné.

2. Procédé de commande à distance selon revendication 1, **caractérisé en ce que** le code contient des lots de code pouvant être attribués à chaque consommateur.

3. Procédé de commande à distance selon les revendications 1 ou 3, **caractérisé en ce que** des procédures complexes d'utilisation peuvent être saisies, enregistrées et affichées au PC (1) et peuvent être exécutées plus tard par l'introduction de la commande correspondante au PC (1).

4. Système pour la commande à distance vocale de consommateurs électriques, comportant
- un ordinateur personnel (PC) (1), en tant qu'unité centrale, présentant une interface de canal vocal (14 ; 140) pour la réception et l'identification d'ordres vocaux afin de les transformer en des ordres de commande correspondants pour commander les consommateurs (20),
- au moins un canal vocal (110), raccordé au PC (1) par l'intermédiaire d'un convertisseur électroacoustique (100) par l'interface de canal vocal (14, 140), et
- un réseau de commande à distance, comportant une ligne à fibres de verre (90), reliant le ou les consommateurs (20) au PC (1), un programme courant d'identification vocale étant installé dans le PC (1),
où le réseau de commande à distance comprend un circuit de transmission infrarouge (3), et le PC (1) comporte :
- un moyen d'enregistrement pour enregistrer un code et un moyen de codage pour, sous forme de signaux codés, coder chaque ordre de commande généré sur la base des ordres vocaux reçus par le programme d'identification vocale,
- un équipement de saisie (13) pour introduire et modifier le code et pour l'attribuer au consommateur correspondant (20),
- un écran relié au PC (1), sur lequel peut être généré sous forme d'un environnement graphique un affichage optique pouvant être attribué à chaque consommateur depuis le PC (1),
- une interface (17) vers le réseau de commande à distance, avec un émetteur infrarouge ;
- des moyens pour transmettre aux différents consommateurs électriques (20) les signaux à codage IR, par l'intermédiaire du réseau de commande à distance comportant une ligne à fibres de verre (90),
un récepteur infrarouge (30), attribué au consommateur (20), recevant le signal IR correspondant, transmis par le réseau de commande à distance comportant la ligne à fibres de verre (90) et le circuit de transmission IR (3).

5. Système de commande à distance selon la revendication 4, **caractérisé en ce que** le code comprend des lots de codes standard de chaque commande à distance pour tous les types de consommateurs pouvant lui être reliés.

6. Système de commande à distance selon les revendications 4 ou 5, **caractérisé en ce que** plusieurs convertisseurs électroacoustiques (100, 101, 102, ...) peuvent être reliés au PC (1) par l'interface de canal vocal et que plusieurs canaux vocaux (110, 111, 112, ...) sont répartis dans plusieurs locaux.

7. Système de commande à distance selon les revendications 4 ou 5, **caractérisé en ce que** le réseau de commande à distance (50) est raccordé en étoile aux différents consommateurs (20).

8. Système de commande à distance selon les revendications 4 ou 5, **caractérisé en ce que** le réseau de commande à distance présente une structure bus.
